# EUROPEAN PATENT APPLICATION

(11) **EP 4 807 792 A1**
(43) Date of publication of application: **16.09.2026**
(21) Application number: 24899544.1
(22) Date of filing: 05.11.2024
(51) Int. Cl.: H01L 23/482

(54) **RADIO FREQUENCY MODULE AND MANUFACTURING METHOD THEREFOR, AND ELECTRONIC DEVICE**

(30) Priority: 04.12.2023 CN 202311648119
(71) Applicant: Huawei Technologies Co., Ltd., Shenzhen, Guangdong 518129 (CN)
(72) Inventor: LIN, Yanhai, Shenzhen, Guangdong 518129 (CN); HUANG, Shujun, Shenzhen, Guangdong 518129 (CN); JIANG, Ran, Shenzhen, Guangdong 518129 (CN); MA, Chenxuan, Shenzhen, Guangdong 518129 (CN)
(74) Representative: Gill Jennings & Every LLP
(86) International application number: PCT/CN2024/129993
(87) International publication number: WO 2025/118901

(57) **Abstract**

This application provides a radio frequency module and a preparation method therefor, and an electronic device. A conductive layer is used to replace bonding wires to implement an electrical connection between a first electronic component and a second electronic component, to avoid a limitation on evolution of a packaging form of the radio frequency module, thereby improving a decoupling capability between the first electronic component and the second electronic component. The radio frequency module includes the first electronic component, the second electronic component, a dielectric layer, and the conductive layer. The first electronic component includes a first connection pad, and the second electronic component includes a second connection pad. The dielectric layer includes first through holes and a second through hole, and a quantity of the first through holes is m. The conductive layer is arranged on the dielectric layer, where the conductive layer includes first conductive branches and a second conductive branch; and a quantity of the first conductive branches is m, an i^{th} first conductive branch is electrically connected to the first connection pad through an i^{th} first through hole, and the second conductive branch is electrically connected to the second connection pad through the second through hole, where m is an integer greater than or equal to 2, and i is a positive integer less than or equal to m.

## Description

This application claims priority to Chinese Patent Application No. 202311648119.5, filed with the China National Intellectual Property Administration on December 4, 2023 and entitled "RADIO FREQUENCY MODULE AND PREPARATION METHOD THEREFOR, AND ELECTRONIC DEVICE", which is incorporated herein by reference in its entirety.

### TECHNICAL FIELD

This application relates to the field of semiconductor technologies, and in particular, to a radio frequency module and a preparation method therefor, and an electronic device.

### BACKGROUND

In a mobile communication network, after power amplification is performed on a radio frequency carrier signal through a radio frequency power tube, the radio frequency carrier signal is transmitted from an antenna to space. The radio frequency power tube mainly includes an amplifier bare die, a capacitor bare die, a bonding wire (Bonding wire), and a package structure. In a conventional manner, pads of any two bare dies are electrically connected to each other through bonding wires, to implement impedance matching and transmit a direct current and a radio frequency signal.

However, a single bonding wire establishes a one-to-one point-to-point connection between two bare dies, and quantities of connection nodes that are on pads in the two bare dies and that are connected to a plurality of bonding wires are the same. This results in a low decoupling capability between the corresponding two bare dies, and reduces a degree of freedom of die design.

### SUMMARY

To resolve the foregoing technical problem, this application provides a radio frequency module and a preparation method therefor, and an electronic device. A conductive layer is used to replace bonding wires to implement an electrical connection between a first electronic component and a second electronic component, to avoid a limitation on evolution of a packaging form of the radio frequency module, thereby improving a decoupling capability between the first electronic component and the second electronic component.

According to a first aspect, this application provides a radio frequency module. The radio frequency module includes a first electronic component, a second electronic component, a dielectric layer, and a conductive layer. The first electronic component includes a first connection pad, and the second electronic component includes a second connection pad. The dielectric layer covers the first electronic component and the second electronic component, the dielectric layer includes first through holes and a second through hole, and a quantity of the first through holes is m. The conductive layer is arranged on the dielectric layer, where the conductive layer includes first conductive branches and a second conductive branch; and a quantity of the first conductive branches is m, an i^{th} first conductive branch is electrically connected to the first connection pad through an i^{th} first through hole, and the second conductive branch is electrically connected to the second connection pad through the second through hole, where m is an integer greater than or equal to 2, and i is a positive integer less than or equal to m.

In this application, bonding wires are no longer used to connect the first electronic component and the second electronic component, instead, the dielectric layer and the conductive layer are sequentially formed on the first electronic component and the second electronic component. The first through holes at the dielectric layer expose the first connection pad, and the first through holes of the dielectric layer expose m connection nodes on the first connection pad, so that the first conductive branches at the conductive layer are electrically connected to the first connection pad through the m first through holes. The second through hole at the dielectric layer exposes a connection node on the second connection pad, so that the second conductive branch at the conductive layer is electrically connected to the second connection pad through the second through hole. Therefore, the first electronic component is connected to the second electronic component through the conductive layer. This can avoid a limitation on evolution of a packaging form of the radio frequency module and a difficulty in stacking with another component or a circuit board that are caused by a three-dimensional structure of the bonding wire. The connection node refers to a part that is on the first connection pad and that is exposed by the first through hole, or a part that is on the second connection pad and that is exposed by the second through hole. In other words, the connection node is a part that is on the first connection pad and that is in direct contact with the first conductive branch, or a part that is on the second connection pad and that is in direct contact with the second conductive branch.

In addition, the first conductive branches and the second conductive branch may be equivalent to inductors. In this application, connection paths between the first conductive branches and the second conductive branch are changed by changing patterns of the first conductive branches and the second conductive branch, to change physical lengths of the first conductive branches and the second conductive branch. By adjusting the physical lengths of the first conductive branches and the second conductive branch, and connection manners between the second conductive branch and the m first conductive branches, any required equivalent inductance value can be implemented for the inductor. Therefore, the quantity of the first conductive branches (the first through holes) and a quantity of second conductive branches (second through holes) are not limited in this application, provided that both the quantity of the first conductive branches and the quantity of the first through holes are m. In other words, in the solution in this application, that the quantity of the first through holes needs to be the same as the quantity of the second through holes is not limited, and that the quantity of the first conductive branches needs to be the same as the quantity of the second conductive branches is not limited. Therefore, the solution in this application can improve a decoupling capability between the first electronic component and the second electronic component, and improve a degree of freedom of die design.

Based on this, in a related technology, to meet a requirement of electrically connecting the first electronic component and the second electronic component through a plurality of connection nodes, a quantity of bonding wires is excessively large (for example, 7), to be specific, the seven bonding wires are connected in parallel. Consequently, an equivalent inductance value of an inductor is reduced, and implementation of a larger equivalent inductance value is limited. Further, in a related technology, a quantity of connection nodes and the quantity of the bonding wires are reduced from 7 to 4, but a decrease in the quantity of the connection nodes goes against a design requirement. Further, a related technology proposes extending physical lengths of the seven bonding wires without reducing the quantity of the connection nodes, to increase the equivalent inductance value. However, an increase in the physical lengths of the bonding wires indicates an increase in a spacing between the first electronic component and the second electronic component. As a result, a size of the radio frequency module is increased, and material costs are also indirectly affected.

In the solution of this embodiment of this application, when the spacing between the first electronic component and the second electronic component is not increased, by adjusting the physical lengths of the first conductive branches and the second conductive branch, and the connection manners between the second conductive branch and the m first conductive branches, any required equivalent inductance value can be implemented for the inductor. Therefore, a decrease in the equivalent inductance value of the inductor can be avoided, and an increase in the size of the radio frequency module can also be avoided.

In some possible implementations, every at least two adjacent first conductive branches are connected to a first connection portion, and the second conductive branch is connected to the first connection portion.

In some possible implementations, a quantity of second through holes is n, a quantity of second conductive branches is n, and a j^{th} second conductive branch is electrically connected to the second connection pad through a j^{th} second through hole, where n is an integer greater than or equal to 2, and i is a positive integer less than or equal to n. A value of n is designed, so that the m first conductive branches are electrically connected to the n second conductive branches; and a physical length of each of the second conductive branches and a physical length of each of the first conductive branches are designed, so that inductance values are implemented for different inductors.

In some possible implementations, every at least two adjacent second conductive branches are connected to a second connection portion. The conductive layer further includes a connected conductive branch, and the connected conductive branch is separately connected to the first connection portion and the second connection portion.

To improve phase balance of connection nodes and avoid a large difference between signal delays of paths for signal transmission from the m connection nodes on the first connection pad to n connection nodes on the second connection pad, where the large difference is caused by a large difference between lengths of the paths from the m connection nodes on the first connection pad to the n connection nodes on the second connection pad through the conductive layer, optionally, a total length of any one of the first conductive branches is L1, and a total length of another first conductive branch ranges from (1-0.3)L1 to (1+0.3)L1, where L1 is a positive number. Additionally/Alternatively, when the quantity of the second conductive branches is n, a total length of any one of the second conductive branches is L2, and a total length of another second conductive branch ranges from (1-0.3)L2 to (1+0.3)L2, where L2 is a positive number.

Further, total lengths of the m first conductive branches are the same, and/or total lengths of the n second conductive branches are the same. In this way, a length of a path from any connection node on the first connection pad to any connection node on the second connection pad through the conductive layer is the same as a length of a path from another connection node on the first connection pad to another connection node on the second connection pad through the conductive layer. The signal delays of the paths for signal transmission from the m connection nodes on the first connection pad to the n connection nodes on the second connection pad are the same.

In some possible implementations, in a power combination scenario, a multi-cell design may be used. There are a plurality of first connection pads in the first electronic component, and there are a plurality of second connection pads in the second electronic component. The m first conductive branches are electrically connected to a same first connection pad; or the m first conductive branches are electrically connected to different first connection pads; and/or the n second conductive branches are electrically connected to a same second connection pad; or the n second conductive branches are electrically connected to different second connection pads.

In some possible implementations, the first conductive branches are electrically connected to m first connection nodes on the first connection pad, and the second conductive branch is electrically connected to n second connection nodes on the second connection pad. A spacing between every two adjacent first connection nodes is the same as a spacing between every two adjacent second connection nodes; or a spacing between every two adjacent first connection nodes is different from a spacing between every two adjacent second connection nodes.

In some possible implementations, in a power combination scenario, a multi-die combination design may be used. There are a plurality of conductive layers, and the plurality of conductive layers are arranged at a same layer.

In some possible implementations, first conductive branches at the plurality of conductive layers are electrically connected to different first connection pads in the same first electronic component, and second conductive branches at the plurality of conductive layers are electrically connected to different second connection pads in the same second electronic component.

In some possible implementations, there are a plurality of first electronic components, and the second electronic component is located between adjacent first electronic components; and/or there are a plurality of second electronic components, and the first electronic component is located between adjacent second electronic components.

According to a second aspect, this application provides a preparation method for a radio frequency module, including: providing a first electronic component and a second electronic component, where the first electronic component includes a first connection pad, and the second electronic component includes a second connection pad; covering the first electronic component and the second electronic component with a dielectric layer, where the dielectric layer includes first through holes and a second through hole, and a quantity of the first through holes is m; and forming a conductive layer on the dielectric layer, where the conductive layer includes first conductive branches and a second conductive branch; and a quantity of the first conductive branches is m, an i^{th} first conductive branch is electrically connected to the first connection pad through an i^{th} first through hole, and the second conductive branch is electrically connected to the second connection pad through the second through hole, where m is an integer greater than or equal to 2, and i is a positive integer less than or equal to m.

In some possible implementations, every at least two adjacent first conductive branches are connected to a first connection portion, and the second conductive branch is connected to the first connection portion.

In some possible implementations, a quantity of second through holes is n, a quantity of second conductive branches is n, and a j^{th} second conductive branch is electrically connected to the second connection pad through a j^{th} second through hole, where n is an integer greater than or equal to 2, and i is a positive integer less than or equal to n.

In some possible implementations, every two adjacent second conductive branches are connected to a second connection portion, and/or every three adjacent second conductive branches are connected to a second connection portion. The conductive layer further includes a connected conductive branch, and the connected conductive branch is separately connected to the first connection portion and the second connection portion.

In some possible implementations, a total length of any one of the first conductive branches is L1, and a total length of another first conductive branch ranges from (1-0.3)L1 to (1+0.3)L1, where L1 is a positive number; and/or when the quantity of the second conductive branches is n, a total length of any one of the second conductive branches is L2, and a total length of another second conductive branch ranges from (1-0.3)L2 to (1+0.3)L2, where L2 is a positive number.

In some possible implementations, total lengths of the m first conductive branches are the same; and/or when the quantity of the second conductive branches is n, total lengths of the n second conductive branches are the same.

The second aspect and any one of the implementations of the second aspect respectively correspond to the first aspect and any one of the implementations of the first aspect. For technical effects corresponding to the second aspect and any one of the implementations of the second aspect, refer to technical effects corresponding to the first aspect and any one of the implementations of the first aspect. Details are not described herein again.

According to a third aspect, this application provides an electronic device, including a circuit board and the radio frequency module according to the first aspect, where the radio frequency module is arranged on the circuit board.

The third aspect and any one of the implementations of the third aspect respectively correspond to the first aspect and any one of the implementations of the first aspect. For technical effects corresponding to the third aspect and any one of the implementations of the third aspect, refer to technical effects corresponding to the first aspect and any one of the implementations of the first aspect. Details are not described herein again.

### BRIEF DESCRIPTION OF DRAWINGS

FIG. 1a is a diagram in which an amplifier bare die is electrically connected to a capacitor bare die through bonding wires according to a related technology;
FIG. 1b is a side view of FIG. 1a;
FIG. 2 is a diagram of a radio frequency module according to an embodiment of this application;
FIG. 3a is a diagram of a structure of a conductive layer, a first connection pad, and a second connection pad according to an embodiment of this application;
FIG. 3b is a diagram of a structure of a conductive layer, a first connection pad, and a second connection pad according to an embodiment of this application;
FIG. 3c is a diagram of a structure of a conductive layer, a first connection pad, and a second connection pad according to an embodiment of this application;
FIG. 4a is a top view of bonding wires according to a related technology;
FIG. 4b is a top view of bonding wires according to a related technology;
FIG. 4c is a top view of bonding wires according to a related technology;
FIG. 5a is a diagram of a structure of a conductive layer, a first connection pad, and a second connection pad according to an embodiment of this application;
FIG. 5b is a diagram of a structure of a conductive layer, a first connection pad, and a second connection pad according to an embodiment of this application;
FIG. 6 is a diagram of a structure of a conductive layer, a first connection pad, and a second connection pad according to an embodiment of this application;
FIG. 7 is a diagram of a structure of a conductive layer, a first connection pad, and a second connection pad according to an embodiment of this application;
FIG. 8a is a diagram of a structure of a conductive layer, a first connection pad, and a second connection pad according to an embodiment of this application;
FIG. 8b is a diagram of a structure of a conductive layer, a first connection pad, and a second connection pad according to an embodiment of this application;
FIG. 8c is a diagram of a structure of a conductive layer, a first connection pad, and a second connection pad according to an embodiment of this application;
FIG. 8d is a diagram of a structure of a conductive layer, a first connection pad, and a second connection pad according to an embodiment of this application;
FIG. 9a is a diagram of a structure of a conductive layer, a first connection pad, and a second connection pad according to an embodiment of this application;
FIG. 9b is a diagram of a structure of a conductive layer, a first connection pad, and a second connection pad according to an embodiment of this application;
FIG. 9c is a diagram of a structure of a conductive layer, a first connection pad, and a second connection pad according to an embodiment of this application;
FIG. 9d is a diagram of a structure of a conductive layer, a first connection pad, and a second connection pad according to an embodiment of this application;
FIG. 10a is a diagram of a structure of a conductive layer, a first connection pad, and a second connection pad according to an embodiment of this application;
FIG. 10b is a diagram of a structure of a conductive layer, a first connection pad, and a second connection pad according to an embodiment of this application;
FIG. 10c is a diagram of a structure of a conductive layer, a first connection pad, and a second connection pad according to an embodiment of this application;
FIG. 11a is a diagram of a structure of a conductive layer, a first connection pad, and a second connection pad according to an embodiment of this application;
FIG. 11b is a diagram of a structure of a conductive layer, a first connection pad, and a second connection pad according to an embodiment of this application;
FIG. 12a is a diagram of a structure of a conductive layer, a first connection pad, and a second connection pad according to an embodiment of this application;
FIG. 12b is a diagram of a structure of a conductive layer, a first connection pad, and a second connection pad according to an embodiment of this application;
FIG. 13 is a diagram of a radio frequency module according to an embodiment of this application;
FIG. 14a is a diagram of a radio frequency module according to an embodiment of this application;
FIG. 14b is a diagram of a radio frequency module according to an embodiment of this application; and
FIG. 15 is a flowchart of preparing a radio frequency module according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and the like are intended to distinguish between different objects but do not indicate a specific order of the objects. For example, a first target object, a second target object, and the like are used for distinguishing between different target objects, but are not used for describing a specific order of the target objects.

In embodiments of this application, the term "example" or "for example" indicates giving an example, an illustration, or a description. Any embodiment or design solution described as an "example" or "for example" in embodiments of this application should not be construed as being more preferred or having more advantages than another embodiment or design solution. To be precise, use of the term, for example, "example" or "for example", is intended to present a related concept in a specific manner.

In descriptions of embodiments of this application, unless otherwise specified, "a plurality of" means two or more than two. For example, a plurality of processing units mean two or more processing units, and a plurality of systems mean two or more systems.

Embodiments of this application provide an electronic device. The electronic device may be a device including a radio frequency chip, for example, a communications electronic product, a consumer electronic product, a home electronic product, a vehicle-mounted electronic product, or a financial terminal product.

For example, the communication electronic product is a device including an electronic component like a radio frequency chip, for example, a communication device like a server, a memory, a radar, or a base station. For example, the consumer electronic product is a mobile phone (mobile phone), a tablet computer (tablet computer), a notebook computer, a personal computer (personal computer, PC), a personal digital assistant (personal digital assistant, PDA), a smart wearable product (for example, a smart watch or a smart band), a virtual reality (virtual reality, VR) terminal device, an augmented reality (augmented reality, AR) terminal device, or an unmanned aerial vehicle. For example, the home electronic product is an intelligent door lock, a television, a smart speaker, a refrigerator, and a robotic vacuum cleaner. For example, the vehicle-mounted electronic product is a vehicle-mounted navigator or a vehicle-mounted display. For example, the financial terminal product is an automated teller machine (automated teller machine, ATM) or a terminal for self-help service handling.

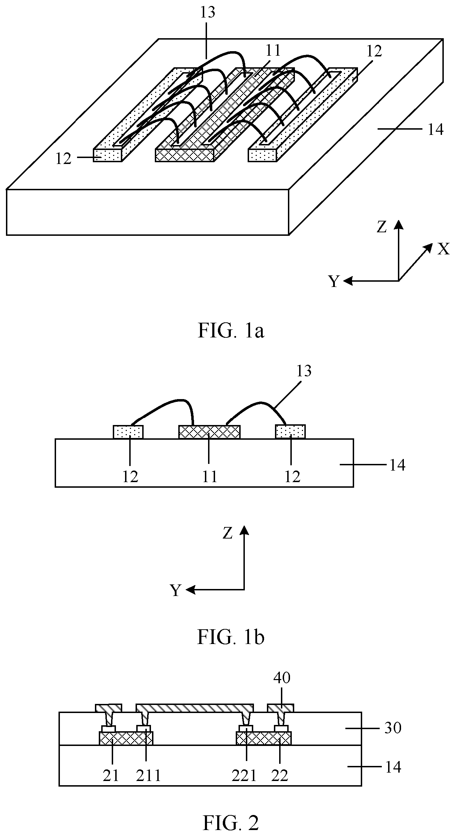

A radio frequency power tube is used as an example. The radio frequency power tube includes a radio frequency chip. For example, as shown in FIG. 1a and FIG. 1b, the radio frequency power tube includes an amplifier bare die 11, a capacitor bare die 12, bonding wires 13, and a packaging structure. A flange 14 is used as a ground plane, and is configured to: carry the amplifier bare die and the capacitor bare die, and implement electrical connections between the amplifier bare die 11 and the ground plane and between the capacitor bare die 12 and the ground plane. In a circuit topology of the radio frequency power tube, the bonding wire 14 may be equivalent to an inductor, to implement different equivalent inductance values by using different connection parameters.

As shown in FIG. 1a and FIG. 1b, in radio frequency design and application, an equipotential design requirement needs to be considered for pad nodes in a same die from the perspective of distributed parameters, to avoid internal signal convection and an increase in an extra loss. For example, a pad in the amplifier bare die 11 is usually connected to a pad in the capacitor bare die 12 through a plurality of bonding wires 13. It can be learned from a bonding device of the bonding wires and a process implementation principle that, each bonding wire 13 is independent, and the plurality of bonding wires 13 are prepared one by one. A preparation process is affected by factors such as a size of a capillary of the device, a wire type, and a tolerance.

However, a solution in which the amplifier bare die 11 is connected to the capacitor bare die 12 through the bonding wires 13 has the following two disadvantages.

First, a single bonding wire establishes a one-to-one point-to-point connection between the amplifier bare die 11 and the capacitor bare die 12. Quantities of connection nodes that are on the pads in the amplifier bare die 11 and the capacitor bare die 12 and that are connected to the plurality of bonding wires 13 need to be the same, and locations of the connection nodes need to be in one-to-one correspondence. This results in a low decoupling capability between the amplifier bare die 11 and the capacitor bare die 12, and reduces a degree of freedom of die design.

In this application, the low decoupling capability between the amplifier bare die 11 and the capacitor bare die 12 means that, when relative locations of the amplifier bare die 11 and the capacitor bare die 12 remain unchanged, removing one connection node from the amplifier bare die 11 or the capacitor bare die 12 causes an irreversible change in an equivalent inductance value of the inductor. In this case, it is considered that the quantities of the connection nodes on the pads in the amplifier bare die 11 and the capacitor bare die 12 need to be in one-to-one correspondence, the locations of the connection nodes also need to be in one-to-one correspondence, and the amplifier bare die and the capacitor bare die cannot be decoupled arbitrarily.

Second, the bonding wire 13 is of a three-dimensional structure, and space needs to be reserved in a vertical direction (a Z direction in the figure). In this case, evolution of a module packaging form is limited, and it is not conducive to stacking or assembling with another component or a circuit board.

Based on this, as shown in FIG. 2, an embodiment of this application provides a radio frequency module. The radio frequency module may include a first electronic component and a second electronic component. The first electronic component and the second electronic component are not limited in embodiments of this application. The first electronic component and the second electronic component may be any two electronic components that need to be electrically connected to each other through pads.

For example, the first electronic component and the second electronic component each may be a bare die, a redistribution layer, an integrated passive device (integrated passive device, IPD), or the like.

The first electronic component 21 includes a first connection pad 211, and the second electronic component includes a second connection pad 221. The first connection pad 211 may also be referred to as a pad or the like, and the second connection pad 221 may also be referred to as a pad or the like.

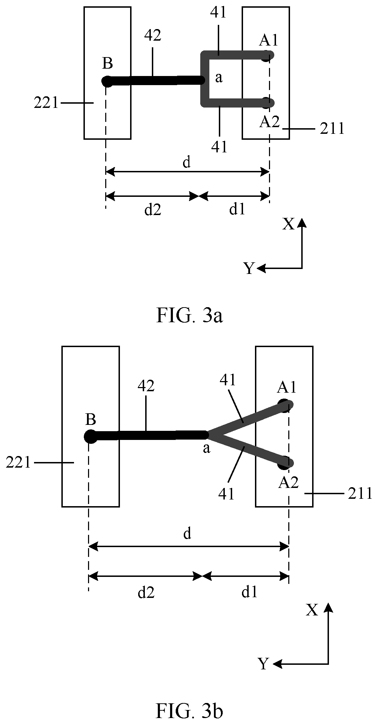

As shown in FIG. 2, the radio frequency module further includes a dielectric layer 30 and a conductive layer 40 (where in the radio frequency field, the conductive layer 40 is configured to transmit a radio frequency signal) that are sequentially stacked on the first electronic component 21 and the second electronic component 22. As shown in FIG. 3a, the dielectric layer 30 covers the first electronic component 21 and the second electronic component 22, the dielectric layer 30 includes first through holes and a second through hole, and a quantity of the first through holes is m. The conductive layer 40 includes first conductive branches 41 and a second conductive branch 42. A quantity of the first conductive branches 41 is m, an i^{th} first conductive branch 41 is electrically connected to the first connection pad 211 through an i^{th} first through hole, and the second conductive branch 42 is electrically connected to the second connection pad 221 through the second through hole. m is an integer greater than or equal to 2, and i is a positive integer less than or equal to m.

In this application, bonding wires 13 are no longer used to connect the first electronic component 21 and the second electronic component 22, instead, the dielectric layer 30 and the conductive layer 40 are sequentially formed on the first electronic component 21 and the second electronic component 22. The first through holes at the dielectric layer 30 expose the first connection pad 211, and the first through holes at the dielectric layer 30 expose m connection nodes on the first connection pad 211, so that the first conductive branches 41 at the conductive layer 40 are electrically connected to the first connection pad 211 through the m first through holes. The second through hole at the dielectric layer 30 exposes a connection node on the second connection pad 221, so that the second conductive branch 42 at the conductive layer 40 is electrically connected to the second connection pad 221 through the second through hole. Therefore, the first electronic component 41 is connected to the second electronic component through the conductive layer 40. This can avoid a limitation on evolution of a packaging form of the radio frequency module and a difficulty in stacking with another component or a circuit board that are caused by a three-dimensional structure of the bonding wire 13. The connection node refers to a part that is on the first connection pad 211 and that is exposed by the first through hole, or a part that is on the second connection pad 221 and that is exposed by the second through hole. In other words, the connection node is a part that is on the first connection pad 211 and that is in direct contact with the first conductive branch 41, or a part that is on the second connection pad 221 and that is in direct contact with the second conductive branch 42.

In addition, the first conductive branches 41 and the second conductive branch 42 may be equivalent to inductors. In embodiments of this application, connection paths between the first conductive branches 41 and the second conductive branch 42 are changed by changing patterns of the first conductive branches 41 and the second conductive branch 42, to change physical lengths of the first conductive branches 41 and the second conductive branch 42. By adjusting the physical lengths of the first conductive branches 41 and the second conductive branch 42, and connection manners between the second conductive branch 42 and the m first conductive branches 41, any required equivalent inductance value can be implemented for the inductor. Therefore, the quantity of the first conductive branches 41 (the first through holes) and a quantity of second conductive branches 42 (second through holes) are not limited in embodiments of this application, provided that both the quantity of the first conductive branches 41 and the quantity of the first through holes are m. In other words, in the solution in embodiments of this application, that the quantity of the first through holes needs to be the same as the quantity of the second through holes is not limited, and that the quantity of the first conductive branches 41 needs to be the same as the quantity of the second conductive branches 42 is not limited. Therefore, the solution in embodiments of this application can improve a decoupling capability between the first electronic component 21 and the second electronic component 22, and improve a degree of freedom of die design.

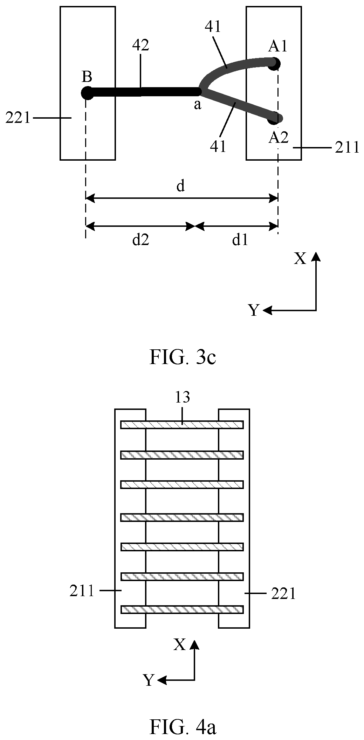

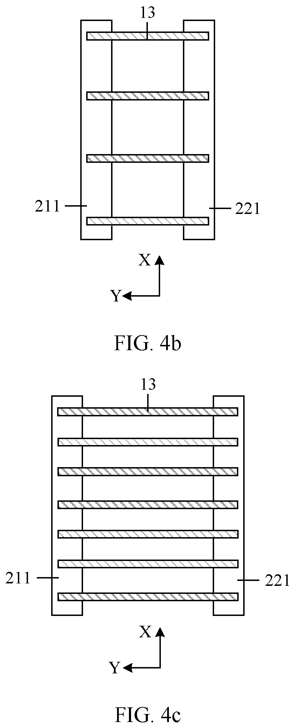

Based on this, as shown in FIG. 4a, in a related technology, to meet a requirement of electrically connecting the first electronic component 21 and the second electronic component 22 through a plurality of connection nodes, a quantity of bonding wires 13 is excessively large (for example, 7), to be specific, the seven bonding wires 13 are connected in parallel. Consequently, an equivalent inductance value of an inductor is reduced, and implementation of a larger equivalent inductance value is limited. Further, as shown in FIG. 4b, in a related technology, a quantity of the connection nodes and the quantity of the bonding wires 13 are reduced from 7 to 4, but a decrease in the quantity of the connection nodes goes against a design requirement. Further, as shown in FIG. 4c, a related technology proposes extending physical lengths of the seven bonding wires 13 without reducing the quantity of the connection nodes, to increase the equivalent inductance value. However, an increase in the physical lengths of the bonding wires 13 indicates an increase in a spacing between the first electronic component 21 and the second electronic component 22. As a result, a size of the radio frequency module is increased, and material costs are also indirectly affected.

In the solution of embodiments of this application, when the spacing between the first electronic component 21 and the second electronic component 22 is not increased, by adjusting the physical lengths of the first conductive branches 41 and the second conductive branch 42, and the connection manners between the second conductive branch 42 and the m first conductive branches 41, any required equivalent inductance value can be implemented for the inductor. Therefore, a decrease in the equivalent inductance value of the inductor can be avoided, and an increase in the size of the radio frequency module can also be avoided.

With reference to the accompanying drawings, the following describes, by using examples, connection relationships between the second conductive branch 42 and the first conductive branches 41 at the conductive layer 40 when m is set to different values.

For example, as shown in FIG. 3a to FIG. 3c, m is equal to 2, both the quantity of the first through holes and the quantity of the first conductive branches 41 are 2, and both the quantity of the second through holes and the quantity of the second conductive branches 42 are 1. The two first conductive branches 41 are electrically connected to the first connection pad 211 respectively through the first through holes, and the second conductive branch 42 is electrically connected to the second connection pad 221 through the second through hole. The two first conductive branches 41 are connected to a first connection portion a, and the second conductive branch 42 is connected to a plurality of first connection portions a.

It is assumed that an equivalent inductance value of an inductor formed by the second conductive branch 42 and the two first conductive branches 41 is L. In this case, an equivalent inductance value from a connection node A1 on the first connection pad 211 to the first connection portion a is L(1-1), and a distance from the connection node A1 on the first connection pad 211 to the first connection portion a in a Y direction is d1; an equivalent inductance value from a connection node A2 on the first connection pad 211 to the first connection portion a is L(1-2), and a distance from the connection node A2 on the first connection pad 211 to the first connection portion a in the Y direction is d1; and an equivalent inductance value from a connection node B on the second connection pad 221 to the first connection portion a is L(2-1), and a distance from the connection node B on the second connection pad 221 to the first connection portion a in the Y direction is d2.

The equivalent inductance value L of the inductor is equal to L(2-1)+L(1-1)//L(1-2). The equivalent inductance value L of the inductor can be adjusted by adjusting a ratio of d1 to d2.

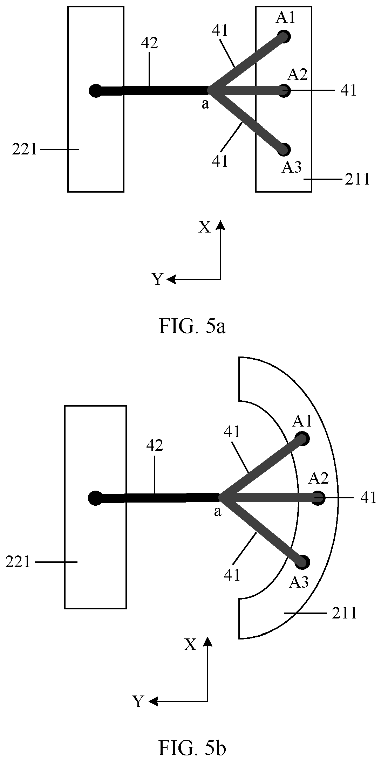

For another example, as shown in FIG. 5a and FIG. 5b, m is equal to 3, both the quantity of the first through holes and the quantity of the first conductive branches 41 are 3, and both the quantity of the second through holes and the quantity of the second conductive branches 42 are 1. Every three adjacent first conductive branches 41 are connected to a first connection portion a, and the second conductive branch 42 is connected to a plurality of first connection portions a. Similarly, an equivalent inductance value L of an inductor can be adjusted by adjusting distances between the first conductive branches 41 and the second conductive branch 42 in a Y direction.

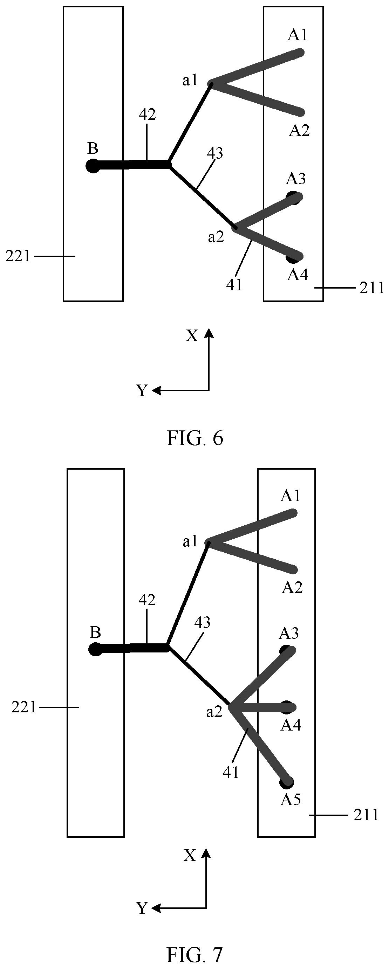

For another example, as shown in FIG. 6, m is equal to 4, both the quantity of the first through holes and the quantity of the first conductive branches 41 are 4, and both the quantity of the second through holes and the quantity of the second conductive branches 42 are 1. A 1^{st} first conductive branch 41 and a 2^{nd} first conductive branch 41 are connected to a first connection portion a1, and a 3^{rd} first conductive branch 41 and a 4^{th} first conductive branch 41 are connected to a first connection portion a2. Based on this, the conductive layer 40 further includes a connected conductive branch 43, where the connected conductive branch 43 is separately connected to the second conductive branch 42, the first connection portion a1, and the first connection portion a2.

Similarly, an equivalent inductance value L of an inductor can be adjusted by adjusting physical lengths of the four first conductive branches 41, the connected conductive branch 43, and the second conductive branch 42.

For another example, as shown in FIG. 7, m is equal to 5, both the quantity of the first through holes and the quantity of the first conductive branches 41 are 5, and both the quantity of the second through holes and the quantity of the second conductive branches 42 are 1. A 1^{st} first conductive branch 41 and a 2^{nd} first conductive branch 41 are connected to a first connection portion a1, and a 3^{rd} first conductive branch 41, a 4^{th} first conductive branch 41, and a 5^{th} first conductive branch 41 are connected to a first connection portion a2. Based on this, the conductive layer 40 further includes a connected conductive branch 43, where the connected conductive branch 43 is separately connected to the second conductive branch 42, the first connection portion a1, and the first connection portion a2.

Similarly, an equivalent inductance value L of an inductor can be adjusted by adjusting physical lengths of the five first conductive branches 41, the connected conductive branch 43, and the second conductive branch 42.

In the foregoing examples, every two adjacent first conductive branches 41 are connected to a first connection portion, and/or every three adjacent first conductive branches 41 are connected to a first connection portion. Certainly, more first conductive branches 41 may be connected to a first connection portion. That is, every at least two adjacent first conductive branches 41 are connected to a first connection portion.

In some possible implementations, an arrangement manner of the m first through holes is not limited in embodiments of this application. Optionally, the m first through holes are arranged in a first direction (an X direction). As shown in FIG. 3a and FIG. 3b, the X direction is perpendicular to the Y direction. Alternatively, as shown in FIG. 3c, a connection line in the first direction is an arc.

Certainly, the first direction depends on arrangement locations of the plurality of connection nodes on the first connection pad 211, and the first direction may alternatively be another direction. This is not limited in embodiments of this application.

The quantity of the second through holes and the quantity of the second conductive branches 42 are not limited in embodiments of this application. At the conductive layer 40 shown in FIG. 3a to FIG. 7, both the quantity of the second through holes and the quantity of the second conductive branches 42 are 1.

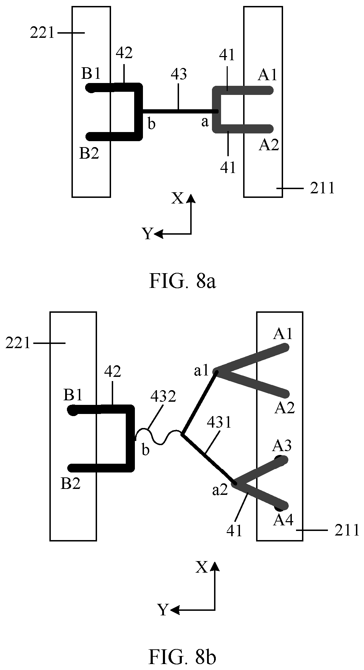

In some other possible implementations, as shown in FIG. 8a to FIG. 8c, the quantity of the second through holes is n, the quantity of the second conductive branches 42 is n, and a j^{th} second conductive branch 42 is electrically connected to the second connection pad through a j^{th} second through hole, where n is an integer greater than or equal to 2, and i is a positive integer less than or equal to n. A value of n is designed, so that the m first conductive branches 41 are electrically connected to the n second conductive branches 42; and a physical length of each of the second conductive branches 42 and a physical length of each of the first conductive branches 41 are designed, so that inductance values are implemented for different inductors.

Every at least two adjacent second conductive branches 42 are connected to a second connection portion. For example, every two adjacent second conductive branches 42 are connected to a second connection portion b, and/or every three adjacent second conductive branches 42 are connected to a second connection portion b.

As shown in FIG. 8a, when there is one first connection portion a and one second connection portion b, the first connection portion a is connected to the second connection portion b through the connected conductive branch 43.

As shown in FIG. 8b, when there are a plurality of (for example, two) first connection portions a and one second connection portion b, the connected conductive branch 43 includes a first connected conductive branch 431 and a second connected conductive branch 432. A first connection portion a1 is connected to a first connection portion a2 through the first connected conductive branch 431, and the first connected conductive branch 431 is connected to the second connection portion b through the second connected conductive branch 432.

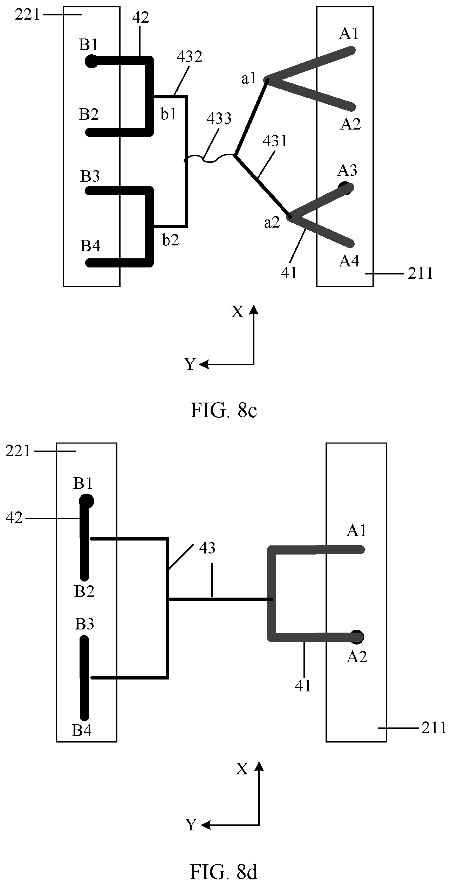

As shown in FIG. 8c, when there are a plurality of (for example, two) first connection portions a and a plurality of (for example, two) second connection portions b, the connected conductive branch 43 includes a first connected conductive branch 431, a second connected conductive branch 432, and a third connected conductive branch 433. A first connection portion a1 is connected to a first connection portion a2 through the first connected conductive branch 431, a second connection portion b1 is connected to a second connection portion b2 through the second connected conductive branch 432, and the first connected conductive branch 431 is connected to the second connected conductive branch 432 through the third connected conductive branch 433.

In some possible implementations, as shown in FIG. 8a to FIG. 8c, a shape of each connected conductive branch 43 is not limited in embodiments of this application, provided that a physical length of each connected conductive branch 43 meets an equivalent inductance value required for design.

In some possible implementations, shapes and total lengths of each of the first conductive branches 41 and each of the second conductive branches 42 are not limited in embodiments of this application. Therefore, lengths of paths from the m connection nodes on the first connection pad 211 to n connection nodes on the second connection pad 221 through the conductive layer 40 are not limited.

However, to improve phase balance of connection nodes and avoid a large difference between signal delays of paths for signal transmission from the m connection nodes on the first connection pad 211 to the n connection nodes on the second connection pad 221, where the large difference is caused by a large difference between the lengths of the paths from the m connection nodes on the first connection pad 211 to the n connection nodes on the second connection pad 221 through the conductive layer 40, optionally, a total length of any one of the first conductive branches 41 is L1, and a total length of another first conductive branch 41 ranges from (1-0.3)L1 to (1+0.3)L1, where L1 is a positive number. Additionally/Alternatively, when the quantity of the second conductive branches is n, a total length of any one of the second conductive branches 42 is L2, and a total length of another second conductive branch 42 ranges from (1-0.3)L2 to (1+0.3)L2, where L2 is a positive number.

Further, as shown in FIG. 2a, FIG. 2b, FIG. 5b, FIG. 6, and FIG. 8a to FIG. 8c, total lengths of the m first conductive branches 41 are the same, and/or total lengths of the n second conductive branches 42 are the same. In this way, a length of a path from any connection node on the first connection pad 211 to any connection node on the second connection pad 221 through the conductive layer 40 is the same as a length of a path from another connection node on the first connection pad 211 to another connection node on the second connection pad 221 through the conductive layer 40. The signal delays of the paths for signal transmission from the m connection nodes on the first connection pad 211 to the n connection nodes on the second connection pad 221 are the same.

Certainly, the m first conductive branches 41 may be connected to the n second conductive branches 42 through the connected conductive branch 43 in another manner. This is not limited in embodiments of this application. For example, as shown in FIG. 8d, every two adjacent second conductive branches 42 may be shared, and/or every two adjacent first conductive branches 41 may be shared.

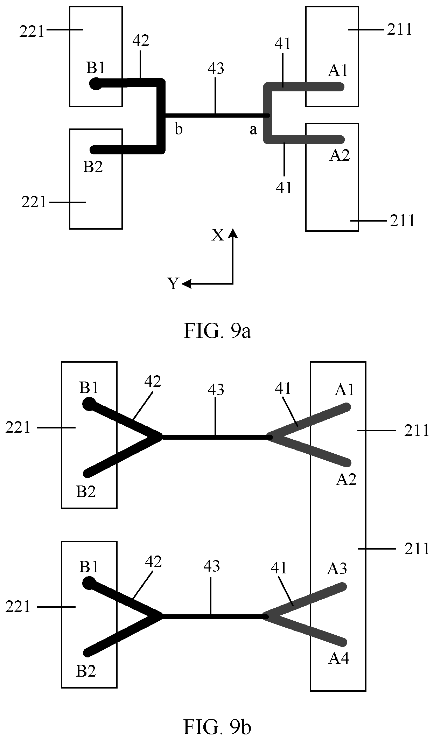

As shown in FIG. 8a to FIG. 8c, the foregoing describes a case in which the m first conductive branches 41 are electrically connected to a same first connection pad 211 respectively through the m first through holes, and the n second conductive branches 42 are electrically connected to a same second connection pad 221 respectively through the n second through holes. In some other embodiments, as shown in FIG. 9a and FIG. 9b, there are a plurality of first connection pads 211 in the first electronic component 21, and there are a plurality of second connection pads 221 in the second electronic component 22. The m first conductive branches 41 are electrically connected to different first connection pads 211, and/or the n second conductive branches 42 are electrically connected to different second connection pads 221.

For example, as shown in FIG. 9a, in a power combination scenario, a multi-cell (cell) design may be used. Two first conductive branches 41 are electrically connected to two first connection pads 211 respectively, and two second conductive branches 42 are electrically connected to two second connection pads 221 respectively. A connection node A1 and a connection node A2 on a same first connection pad 211 are equipotential, and a connection node B1 and a connection node B2 on a same second connection pad 221 are equipotential.

For another example, as shown in FIG. 9b, in a power combination scenario, a multi-cell (cell) design may be used. Four first conductive branches 41 are electrically connected to a same first connection pad 211, a 1^{st} second conductive branch 42 and a 2^{nd} second conductive branch 42 are electrically connected to a 1^{st} second connection pad 221, and a 3^{rd} second conductive branch 42 and a 4^{th} second conductive branch 42 are electrically connected to a 2^{nd} second connection pad 221. A connection node A1, a connection node A2, a connection node A3, and a connection node A4 on the same first connection pad 211 are equipotential, and a connection node B1 and a connection node B2 on a same second connection pad 221 are equipotential.

The example shown in FIG. 9b may be applied to a combiner. The 1^{st} second connection pad 221 in the second electronic component 22 is configured to transmit a first signal, the 2^{nd} second connection pad 221 in the second electronic component 22 is configured to transmit a second signal, and the first signal and the second signal are transmitted to the same first connection pad 211 in the first electronic component 21 through the conductive layer 40, to implement signal combination.

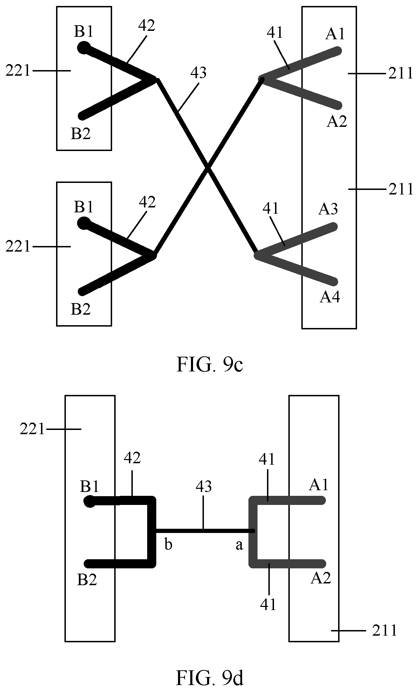

In some possible implementations, in the example shown in FIG. 9b, a 1^{st} first conductive branch 41 and a 2^{nd} first conductive branch 41 are connected to a first connection portion a1, a 3^{rd} first conductive branch 41 and a 4^{th} first conductive branch 41 are connected to a first connection portion a2, the 1^{st} second conductive branch 42 and the 2^{nd} second conductive branch 42 are connected to a second connection portion b1, and the 3^{rd} second conductive branch 42 and the 4^{th} second conductive branch 42 are connected to a second connection portion b2. Based on the example shown in FIG. 9b, as shown in FIG. 9c, the first connection portion a1, the first connection portion a2, the second connection portion b1, and the second connection portion b2 are connected to each other through the connected conductive branch 43.

It should be understood that a plurality of connection nodes on a same first connection pad 211 are electrically connected, and a plurality of connection nodes on a same second connection pad 221 are electrically connected. A plurality of connection nodes on different first connection pads 211 are electrically isolated, and a plurality of connection nodes on a same second connection pad 221 are electrically isolated.

In some embodiments, the first conductive branches 41 are electrically connected to m first connection nodes on the first connection pad 211, and the second conductive branches 42 are electrically connected to n second connection nodes on the second connection pad 221. As shown in FIG. 9b and FIG. 9c, a distance between every two adjacent first connection nodes is different from a distance between every two adjacent second connection nodes; or as shown in FIG. 9d, a distance between every two adjacent first connection nodes is the same as a distance between every two adjacent second connection nodes.

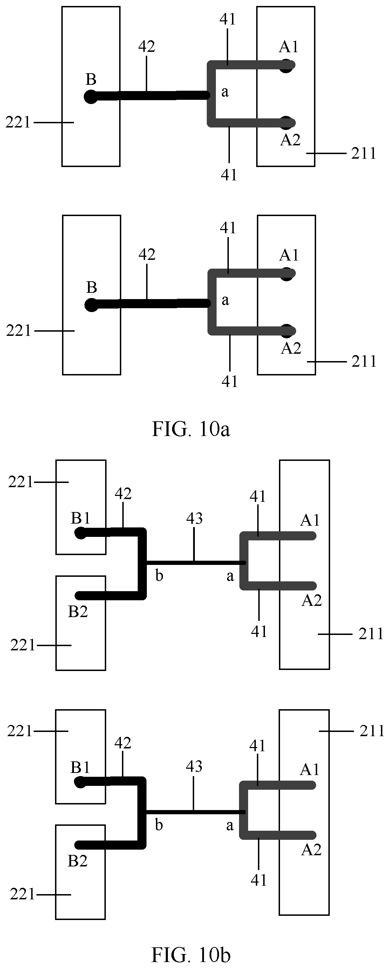

In some embodiments, as shown in FIG. 10a to FIG. 10c, in a power combination scenario, a multi-die (die) combination design may be used. There are a plurality of conductive layers 40, and the plurality of conductive layers 40 are arranged at a same layer. An arrangement manner of the plurality of conductive layers 40 is not limited in embodiments of this application. The arrangement manner of the plurality of conductive layers 40 depends on locations and an arrangement manner of the first connection pad 211 and the second connection pad 221 that are electrically connected to the plurality of conductive layers 40. For example, the plurality of conductive layers 40 are arranged in the X direction.

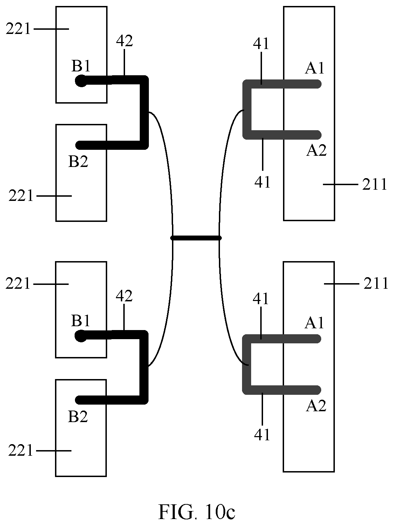

In some possible implementations, due to a design requirement, a plurality of first connection pads 211 and a plurality of second connection pads 221 that correspond to the plurality of conductive layers 40 need to be electrically connected to each other. Based on this, as shown in FIG. 10c, in embodiments of this application, first conductive branches 41 at the plurality of conductive layers 40 are further electrically connected to different first connection pads 211 in a same first electronic component 21, and second conductive branches 42 at the plurality of conductive layers 40 are further electrically connected to different second connection pads in a same second electronic component 22.

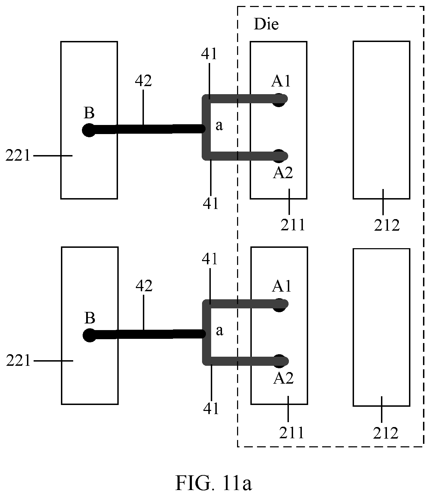

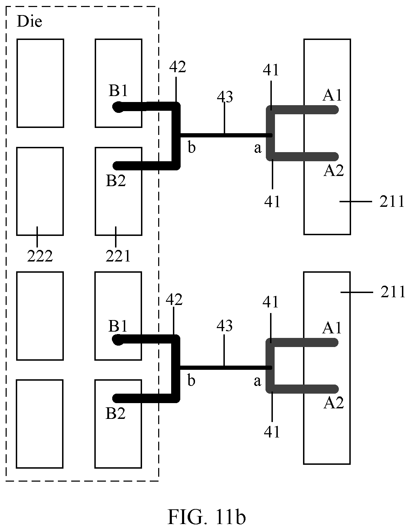

In some possible implementations, as shown in FIG. 11a and FIG. 11b, in addition to the first connection pads 211, the first electronic component 21 may further include third connection pads 212; and/or in addition to the second connection pads 221, the second electronic component 22 may further include fourth connection pads 222. The third connection pads 212 and the fourth connection pads 222 may further implement other functions. This is not limited in embodiments of this application.

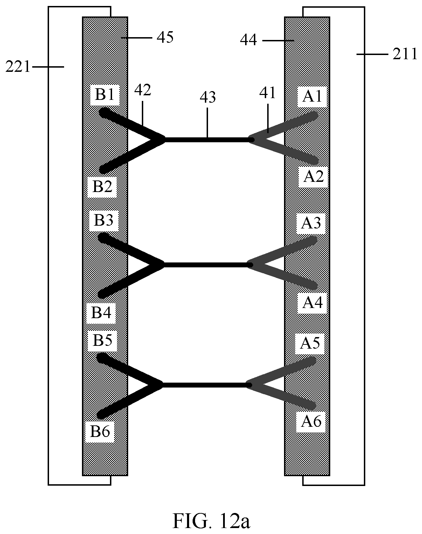

In some possible implementations, as shown in FIG. 12a, in addition to the foregoing first conductive branch 41, second conductive branch 42, and connected conductive branch 43, the conductive layer 40 may further include a first auxiliary conductive layer 44 and a second auxiliary conductive layer 45. The first conductive branch 41 is electrically connected to the first connection pad 211 through the first auxiliary conductive layer 44, and the second conductive branch 42 is electrically connected to the second connection pad 221 through the second auxiliary conductive layer 45.

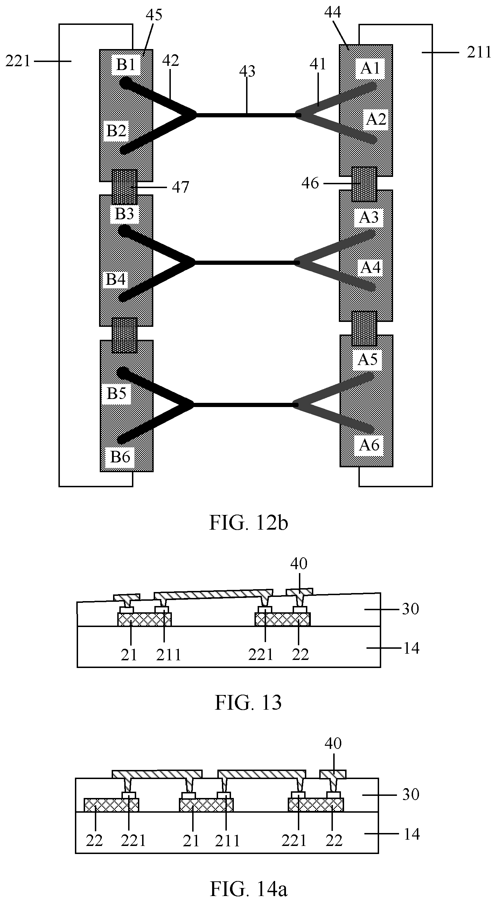

Based on this, as shown in FIG. 12b, there are a plurality of first auxiliary conductive layers 44 and a plurality of second auxiliary conductive layers 45, a radio frequency chip may further include first components 46 and second components 47, two adjacent first auxiliary conductive layers 44 are electrically connected to each other through a first component 46, and two adjacent second auxiliary conductive layers 44 are electrically connected to each other through a second component 47. The first component 46 and the second component 47 each may be a surface mount device resistor, a surface mount device capacitor, a resistor formed by a thin film, a capacitor formed by a thin film, or the like.

In some possible implementations, as shown in FIG. 2, a surface that is of the dielectric layer 30 and that is away from the first electronic component 21 may be a flat surface; or as shown in FIG. 13, a surface that is of a dielectric layer 30 and that is away from a first electronic component 21 may be an oblique surface. This is not limited in embodiments of this application.

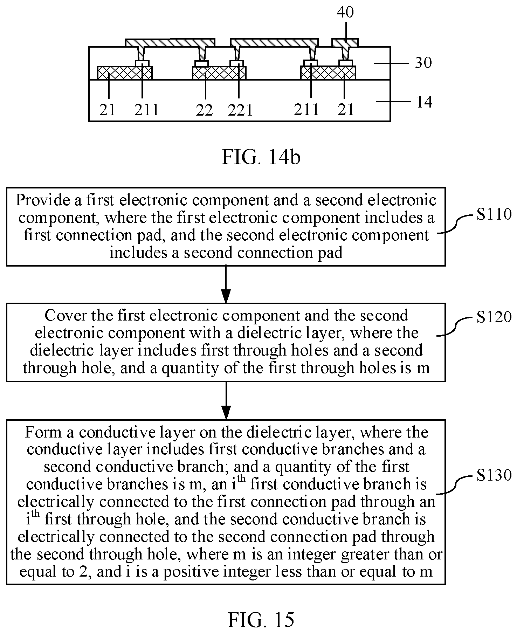

The foregoing describes a case in which the radio frequency module includes one first electronic component 21 and one second electronic component 22. In some other embodiments, as shown in FIG. 14a and FIG. 14b, there are a plurality of first electronic components 21, and the second electronic component 22 is located between adjacent first electronic components 21; and/or there are a plurality of second electronic components 22, and the first electronic component 21 is located between adjacent second electronic components 22.

In another embodiment, this application further provides a preparation method for a radio frequency module. As shown in FIG. 15, the method may be implemented by performing the following steps:
S110: Provide a first electronic component 21 and a second electronic component 22, where the first electronic component 21 includes a first connection pad 211, and the second electronic component 22 includes a second connection pad 221.
S120: Cover the first electronic component 21 and the second electronic component 22 with a dielectric layer 30, where the dielectric layer 30 includes first through holes and a second through hole, and a quantity of the first through holes is m.
S130: Form a conductive layer 40 on the dielectric layer 30, where the conductive layer 40 includes first conductive branches 41 and a second conductive branch 42. A quantity of the first conductive branches 41 is m, an i^{th} first conductive branch 41 is electrically connected to the first connection pad 211 through an i^{th} first through hole, and the second conductive branch 42 is electrically connected to the second connection pad 221 through the second through hole, where m is an integer greater than or equal to 2, and i is a positive integer less than or equal to m.

In this application, bonding wires 13 are no longer used to connect the first electronic component 21 and the second electronic component 22, instead, the dielectric layer 30 and the conductive layer 40 are sequentially formed on the first electronic component 21 and the second electronic component 22. The first through holes at the dielectric layer 30 expose the first connection pad 211, and the first through holes at the dielectric layer 30 expose m connection nodes on the first connection pad 211, so that the first conductive branches 41 at the conductive layer 40 are electrically connected to the first connection pad 211 through the m first through holes. The second through hole at the dielectric layer 30 exposes a connection node on the second connection pad 221, so that the second conductive branch 42 at the conductive layer 40 is electrically connected to the second connection pad 221 through the second through hole. Therefore, the first electronic component 41 is connected to the second electronic component through the conductive layer 40. This can avoid a limitation on evolution of a packaging form of the radio frequency module and a difficulty in stacking with another component or a circuit board that are caused by a three-dimensional structure of the bonding wire 13. The connection node refers to a part that is on the first connection pad 211 and that is exposed by the first through hole, or a part that is on the second connection pad 221 and that is exposed by the second through hole. In other words, the connection node is a part that is on the first connection pad 211 and that is in direct contact with the first conductive branch 41, or a part that is on the second connection pad 221 and that is in direct contact with the second conductive branch 42.

In addition, the first conductive branches 41 and the second conductive branch 42 may be equivalent to inductors. In embodiments of this application, connection paths between the first conductive branches 41 and the second conductive branch 42 are changed by changing patterns of the first conductive branches 41 and the second conductive branch 42, to change a physical length of each of the first conductive branches 41 and the second conductive branch 42. By adjusting the physical length of each of the first conductive branches 41 and the second conductive branch 42, and connection manners between the second conductive branch 42 and the m first conductive branches 41, any required equivalent inductance value can be implemented for the inductor. Therefore, the quantity of the first conductive branches 41 (the first through holes) and a quantity of second conductive branches 42 (second through holes) are not limited in embodiments of this application, provided that both the quantity of the first conductive branches 41 and the quantity of the first through holes are m. In other words, in the solution in embodiments of this application, that the quantity of the first through holes needs to be the same as the quantity of the second through holes is not limited, and that the quantity of the first conductive branches 41 needs to be the same as the quantity of the second conductive branches 42 is not limited. Therefore, the solution in embodiments of this application can improve a decoupling capability between the first electronic component 21 and the second electronic component 22, and improve a degree of freedom of die design.

Based on this, as shown in FIG. 4a, in a related technology, to meet a requirement of electrically connecting the first electronic component 21 and the second electronic component 22 through a plurality of connection nodes, a quantity of bonding wires 13 is excessively large (for example, 7), to be specific, the seven bonding wires 13 are connected in parallel. Consequently, an equivalent inductance value of an inductor is reduced, and implementation of a larger equivalent inductance value is limited. Further, as shown in FIG. 4b, in a related technology, a quantity of the connection nodes and the quantity of the bonding wires 13 are reduced from 7 to 4, but a decrease in the quantity of the connection nodes goes against a design requirement. Further, as shown in FIG. 4c, a related technology proposes extending physical lengths of the seven bonding wires 13 without reducing the quantity of the connection nodes, to increase the equivalent inductance value. However, an increase in the physical lengths of the bonding wires 13 indicates an increase in a spacing between the first electronic component 21 and the second electronic component 22. As a result, a size of the radio frequency module is increased, and material costs are also indirectly affected.

In the solution of embodiments of this application, when the spacing between the first electronic component 21 and the second electronic component 22 is not increased, by adjusting the physical length of each of the first conductive branches 41 and the second conductive branch 42, and the connection manners between the second conductive branch 42 and the m first conductive branches 41, any required equivalent inductance value can be implemented for the inductor. Therefore, a decrease in the equivalent inductance value of the inductor can be avoided, and an increase in the size of the radio frequency module can also be avoided.

With reference to the accompanying drawings, the following describes, by using examples, connection relationships between the second conductive branch 42 and the first conductive branches 41 at the conductive layer 40 when m is set to different values.

For example, as shown in FIG. 3a to FIG. 3c, m is equal to 2, both the quantity of the first through holes and the quantity of the first conductive branches 41 are 2, and both the quantity of the first through holes and the quantity of the second conductive branches 42 are 1. The two first conductive branches 41 are electrically connected to the first connection pad 211 respectively through the first through holes, and the second conductive branch 42 is electrically connected to the second connection pad 221 through the second through hole. The two first conductive branches 41 are connected to a first connection portion a, and the second conductive branch 42 is connected to a plurality of first connection portions a.

It is assumed that an equivalent inductance value of an inductor formed by the second conductive branch 42 and the two first conductive branches 41 is L. In this case, an equivalent inductance value from a connection node A1 on the first connection pad 211 to the first connection portion a is L(1-1), and a distance from the connection node A1 on the first connection pad 211 to the first connection portion a in a Y direction is d1, an equivalent inductance value from a connection node A2 on the first connection pad 211 to the first connection portion a is L(1-2), and a distance from the connection node A2 on the first connection pad 211 to the first connection portion a in the Y direction is d1, and an equivalent inductance value from a connection node B on the second connection pad 221 to the first connection portion a is L(2-1), and a distance from the connection node B on the second connection pad 221 to the first connection portion a in the Y direction is d2.

The equivalent inductance value L of the inductor is equal to L(2-1)+L(1-1)//L(1-2). The equivalent inductance value L of the inductor can be adjusted by adjusting a ratio of d1 to d2.

For another example, as shown in FIG. 5a and FIG. 5b, m is equal to 3, both the quantity of the first through holes and the quantity of the first conductive branches 41 are 3, and both the quantity of the second through holes and the quantity of the second conductive branches 42 are 1. Every three adjacent first conductive branches 41 are connected to a first connection portion a, and the second conductive branch 42 is connected to a plurality of first connection portions a. Similarly, an equivalent inductance value L of an inductor can be adjusted by adjusting distances between the first conductive branches 41 and the second conductive branch 42 in a Y direction.

For another example, as shown in FIG. 6, m is equal to 4, both the quantity of the first through holes and the quantity of the first conductive branches 41 are 4, and both the quantity of the second through holes and the quantity of the second conductive branches 42 are 1. A 1^{st} first conductive branch 41 and a 2^{nd} first conductive branch 41 are connected to a first connection portion a1, and a 3^{rd} first conductive branch 41 and a 4^{th} first conductive branch 41 are connected to a first connection portion a2. Based on this, the conductive layer 40 further includes a connected conductive branch 43, where the connected conductive branch 43 is separately connected to the second conductive branch 42, the first connection portion a1, and the first connection portion a2.

Similarly, an equivalent inductance value L of an inductor can be adjusted by adjusting physical lengths of the four first conductive branches 41, the connected conductive branch 43, and the second conductive branch 42.

For another example, as shown in FIG. 7, m is equal to 5, both the quantity of the first through holes and the quantity of the first conductive branches 41 are 5, and both the quantity of the second through holes and the quantity of the second conductive branches 42 are 1. A 1^{st} first conductive branch 41 and a 2^{nd} first conductive branch 41 are connected to a first connection portion a1, and a 3^{rd} first conductive branch 41, a 4^{th} first conductive branch 41, and a 5^{th} first conductive branch 41 are connected to a first connection portion a2. Based on this, the conductive layer 40 further includes a connected conductive branch 43, where the connected conductive branch 43 is separately connected to the second conductive branch 42, the first connection portion a1, and the first connection portion a2.

Similarly, an equivalent inductance value L of an inductor can be adjusted by adjusting physical lengths of the five first conductive branches 41, the connected conductive branch 43, and the second conductive branch 42.

In the foregoing examples, every two adjacent first conductive branches 41 are connected to a first connection portion, and/or every three adjacent first conductive branches 41 are connected to a first connection portion. Certainly, more first conductive branches 41 may be connected to a first connection portion. That is, every at least two adjacent first conductive branches 41 are connected to a first connection portion.

In some possible implementations, an arrangement manner of the m first through holes is not limited in embodiments of this application. Optionally, the m first through holes are arranged in a first direction (an X direction). As shown in FIG. 3a and FIG. 3b, the X direction is perpendicular to the Y direction. Alternatively, as shown in FIG. 3c, a connection line in the first direction is an arc.

Certainly, the first direction depends on arrangement locations of the plurality of connection nodes on the first connection pad 211, and the first direction may alternatively be another direction. This is not limited in embodiments of this application.

The quantity of the second through holes and the quantity of the second conductive branches 42 are not limited in embodiments of this application. At the conductive layer 40 shown in FIG. 3a to FIG. 7, both the quantity of the second through holes and the quantity of the second conductive branches 42 are 1.

In some other possible implementations, as shown in FIG. 8a to FIG. 8c, the quantity of the second through holes is n, the quantity of the second conductive branches 42 is n, and a j^{th} second conductive branch 42 is electrically connected to the second connection pad through a j^{th} second through hole, where n is an integer greater than or equal to 2, and i is a positive integer less than or equal to n.

Every at least two adjacent second conductive branches 42 are connected to a second connection portion. For example, every two adjacent second conductive branches 42 are connected to a second connection portion b, and/or every three adjacent second conductive branches 42 are connected to a second connection portion b.

As shown in FIG. 8a, when there is one first connection portion a and one second connection portion b, the first connection portion a is connected to the second connection portion b through the connected conductive branch 43.

As shown in FIG. 8b, when there are a plurality of (for example, two) first connection portions a and one second connection portion b, the connected conductive branch 43 includes a first connected conductive branch 431 and a second connected conductive branch 432. A first connection portion a1 is connected to a first connection portion a2 through the first connected conductive branch 431, and the first connected conductive branch 431 is connected to the second connection portion b through the second connected conductive branch 432.

As shown in FIG. 8c, when there are a plurality of (for example, two) first connection portions a and a plurality of (for example, two) second connection portions b, the connected conductive branch 43 includes a first connected conductive branch 431, a second connected conductive branch 432, and a third connected conductive branch 433. A first connection portion a1 is connected to a first connection portion a2 through the first connected conductive branch 431, a second connection portion b1 is connected to a second connection portion b2 through the second connected conductive branch 432, and the first connected conductive branch 431 is connected to the second connected conductive branch 432 through the third connected conductive branch 433.

In some possible implementations, as shown in FIG. 8a to FIG. 8c, a shape of each connected conductive branch 43 is not limited in embodiments of this application, provided that a physical length of each connected conductive branch 43 meets an equivalent inductance value required for design.

In some possible implementations, shapes and total lengths of each of the first conductive branches 41 and each of the second conductive branches 42 are not limited in embodiments of this application. Therefore, lengths of paths from the m connection nodes on the first connection pad 211 to n connection nodes on the second connection pad 221 through the conductive layer 40 are not limited.

However, to improve phase balance of connection nodes and avoid a large difference between signal delays of paths for signal transmission from the m connection nodes on the first connection pad 211 to the n connection nodes on the second connection pad 221, where the large difference is caused by a large difference between the lengths of the paths from the m connection nodes on the first connection pad 211 to the n connection nodes on the second connection pad 221 through the conductive layer 40, optionally, a total length of any one of the first conductive branches 41 is L1, and a total length of another first conductive branch 41 ranges from (1-0.3)L1 to (1+0.3)L1, where L1 is a positive number. Additionally/Alternatively, when the quantity of the second conductive branches is n, a total length of any one of the second conductive branches 42 is L2, and a total length of another second conductive branch 42 ranges from (1-0.3)L2 to (1+0.3)L2, where L2 is a positive number.

Further, as shown in FIG. 2a, FIG. 2b, FIG. 5b, FIG. 6, and FIG. 8a to FIG. 8c, total lengths of the m first conductive branches 41 are the same, and/or total lengths of the n second conductive branches 42 are the same. In this way, a length of a path from any connection node on the first connection pad 211 to any connection node on the second connection pad 221 through the conductive layer 40 is the same as a length of a path from another connection node on the first connection pad 211 to another connection node on the second connection pad 221 through the conductive layer 40. The signal delays of the paths for signal transmission from the m connection nodes on the first connection pad 211 to the n connection nodes on the second connection pad 221 are the same.

Certainly, the m first conductive branches 41 may be connected to the n second conductive branches 42 through the connected conductive branch 43 in another manner. This is not limited in embodiments of this application. For example, as shown in FIG. 8d, every two adjacent second conductive branches 42 may be shared, and/or every two adjacent first conductive branches 41 may be shared.

As shown in FIG. 8a to FIG. 8c, the foregoing describes a case in which the m first conductive branches 41 are electrically connected to a same first connection pad 211 respectively through the m first through holes, and the n second conductive branches 42 are electrically connected to a same second connection pad 221 respectively through the n second through holes. In some other embodiments, as shown in FIG. 9a and FIG. 9b, there are a plurality of first connection pads 211 in the first electronic component 21, and there are a plurality of second connection pads 221 in the second electronic component 22. The m first conductive branches 41 are electrically connected to different first connection pads 211, and/or the n second conductive branches 42 are electrically connected to different second connection pads 221.

For example, as shown in FIG. 9a, two first conductive branches 41 are electrically connected to two first connection pads 211 respectively, and two second conductive branches 42 are electrically connected to two second connection pads 221 respectively.

For another example, as shown in FIG. 9b, four first conductive branches 41 are electrically connected to a same first connection pad 211, a 1^{st} second conductive branch 42 and a 2^{nd} second conductive branch 42 are electrically connected to a 1^{st} second connection pad 221, and a 3^{rd} second conductive branch 42 and a 4^{th} second conductive branch 42 are electrically connected to a 2^{nd} second connection pad 221.

The example shown in FIG. 9b may be applied to a combiner. The 1^{st} second connection pad 221 in the second electronic component 22 is configured to transmit a first signal, the 2^{nd} second connection pad 221 in the second electronic component 22 is configured to transmit a second signal, and the first signal and the second signal are transmitted to the same first connection pad 211 in the first electronic component 21 through the conductive layer 40, to implement signal combination.

In some possible implementations, in the example shown in FIG. 9b, a 1^{st} first conductive branch 41 and a 2^{nd} first conductive branch 41 are connected to a first connection portion a1, a 3^{rd} first conductive branch 41 and a 4^{th} first conductive branch 41 are connected to a first connection portion a2, the 1^{st} second conductive branch 42 and the 2^{nd} second conductive branch 42 are connected to a second connection portion b1, and the 3^{rd} second conductive branch 42 and the 4^{th} second conductive branch 42 are connected to a second connection portion b2. Based on the example shown in FIG. 9b, as shown in FIG. 9c, the first connection portion a1, the first connection portion a2, the second connection portion b1, and the second connection portion b2 are connected to each other through the connected conductive branch 43.

It should be understood that a plurality of connection nodes on a same first connection pad 211 are electrically connected, and a plurality of connection nodes on a same second connection pad 221 are electrically connected. A plurality of connection nodes on different first connection pads 211 are electrically isolated, and a plurality of connection nodes on a same second connection pad 221 are electrically isolated.

In some embodiments, as shown in FIG. 10a to FIG. 10c, there are a plurality of conductive layers 40, and the plurality of conductive layers 40 are arranged at a same layer. An arrangement manner of the plurality of conductive layers 40 is not limited in embodiments of this application. The arrangement manner of the plurality of conductive layers 40 depends on locations and an arrangement manner of the first connection pad 211 and the second connection pad 221 that are electrically connected to the plurality of conductive layers 40. For example, the plurality of conductive layers 40 are arranged in the X direction.

In some possible implementations, due to a design requirement, a plurality of first connection pads 211 and a plurality of second connection pads 221 that correspond to the plurality of conductive layers 40 need to be electrically connected to each other. Based on this, as shown in FIG. 10c, in embodiments of this application, first conductive branches 41 at the plurality of conductive layers 40 are further electrically connected to different first connection pads 211 in a same first electronic component 21, and second conductive branches 42 at the plurality of conductive layers 40 are further electrically connected to different second connection pads in a same second electronic component 22.

In some possible implementations, as shown in FIG. 11a and FIG. 11b, in addition to the first connection pads 211, the first electronic component 21 may further include third connection pads 212; and/or in addition to the second connection pads 221, the second electronic component 22 may further include fourth connection pads 222. The third connection pads 212 and the fourth connection pads 222 may further implement other functions. This is not limited in embodiments of this application.

In some possible implementations, as shown in FIG. 12a, in addition to the foregoing first conductive branch 41, second conductive branch 42, and connected conductive branch 43, the conductive layer 40 may further include a first auxiliary conductive layer 44 and a second auxiliary conductive layer 45. The first conductive branch 41 is electrically connected to the first connection pad 211 through the first auxiliary conductive layer 44, and the second conductive branch 42 is electrically connected to the second connection pad 221 through the second auxiliary conductive layer 45.

Based on this, as shown in FIG. 12b, there are a plurality of first auxiliary conductive layers 44 and a plurality of second auxiliary conductive layers 45, a radio frequency chip may further include first components 46 and second components 47, two adjacent first auxiliary conductive layers 44 may be electrically connected to each other through a first component 46, and two adjacent second auxiliary conductive layers 44 may be electrically connected to each other through a second component 47. The first component 46 and the second component 47 each may be a surface mount device resistor, a surface mount device capacitor, a resistor formed by a thin film, a capacitor formed by a thin film, or the like.

In some possible implementations, as shown in FIG. 2, a surface that is of the dielectric layer 30 and that is away from the first electronic component 21 may be a flat surface; or as shown in FIG. 13, a surface that is of a dielectric layer 30 and that is away from a first electronic component 21 may be an oblique surface. This is not limited in embodiments of this application.

The foregoing describes a case in which the radio frequency module includes one first electronic component 21 and one second electronic component 22. In some other embodiments, as shown in FIG. 14a and FIG. 14b, there are a plurality of first electronic components 21, and the second electronic component 22 is located between adjacent first electronic components 21; and/or there are a plurality of second electronic components 22, and the first electronic component 21 is located between adjacent second electronic components 22.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make various forms without departing from the purposes of this application and the protection scope of the claims, and all the forms shall fall within the protection of this application.

## Claims

1. A radio frequency module, comprising:
a first electronic component and a second electronic component, wherein the first electronic component comprises a first connection pad, and the second electronic component comprises a second connection pad;
a dielectric layer covering the first electronic component and the second electronic component, wherein the dielectric layer comprises first through holes and a second through hole, and a quantity of the first through holes is m; and
a conductive layer arranged on the dielectric layer, wherein the conductive layer comprises first conductive branches and a second conductive branch; and
a quantity of the first conductive branches is m, an i^{th} first conductive branch is electrically connected to the first connection pad through an i^{th} first through hole, and the second conductive branch is electrically connected to the second connection pad through the second through hole, wherein m is an integer greater than or equal to 2, and i is a positive integer less than or equal to m.

2. The radio frequency module according to claim 1, wherein every at least two adjacent first conductive branches are connected to a first connection portion, and the second conductive branch is connected to the first connection portion.

3. The radio frequency module according to claim 1 or 2, wherein a quantity of second through holes is n, a quantity of second conductive branches is n, and a j^{th} second conductive branch is electrically connected to the second connection pad through a j^{th} second through hole, wherein n is an integer greater than or equal to 2, and i is a positive integer less than or equal to n.

4. The radio frequency module according to claim 3, wherein every at least two adjacent second conductive branches are connected to a second connection portion; and
the conductive layer further comprises a connected conductive branch, and the connected conductive branch is separately connected to the first connection portion and the second connection portion.

5. The radio frequency module according to any one of claims 2 to 4, wherein a total length of any one of the first conductive branches is L1, and a total length of another first conductive branch ranges from (1-0.3)L1 to (1+0.3)L1, wherein L1 is a positive number; and/or
when the quantity of the second conductive branches is n, a total length of any one of the second conductive branches is L2, and a total length of another second conductive branch ranges from (1-0.3)L2 to (1+0.3)L2, wherein L2 is a positive number.

6. The radio frequency module according to claim 5, wherein total lengths of the m first conductive branches are the same; and/or
when the quantity of the second conductive branches is n, total lengths of the n second conductive branches are the same.

7. The radio frequency module according to any one of claims 3 to 6, wherein there are a plurality of first connection pads in the first electronic component, and there are a plurality of second connection pads in the second electronic component;
the m first conductive branches are electrically connected to a same first connection pad; or the m first conductive branches are electrically connected to different first connection pads; and/or
the n second conductive branches are electrically connected to a same second connection pad; or the n second conductive branches are electrically connected to different second connection pads.

8. The radio frequency module according to any one of claims 3 to 7, wherein the first conductive branches are electrically connected to m first connection nodes on the first connection pad, and the second conductive branches are electrically connected to n second connection nodes on the second connection pad; and
a spacing between every two adjacent first connection nodes is the same as a spacing between every two adjacent second connection nodes; or
a spacing between every two adjacent first connection nodes is different from a spacing between every two adjacent second connection nodes.

9. The radio frequency module according to any one of claims 1 to 8, wherein there are a plurality of conductive layers, and the plurality of conductive layers are arranged at a same layer.

10. The radio frequency module according to claim 9, wherein first conductive branches at the plurality of conductive layers are electrically connected to different first connection pads in the same first electronic component, and second conductive branches at the plurality of conductive layers are electrically connected to different second connection pads in the same second electronic component.

11. The radio frequency module according to any one of claims 1 to 10, wherein there are a plurality of first electronic components, and the second electronic component is located between adjacent first electronic components; and/or
there are a plurality of second electronic components, and the first electronic component is located between adjacent second electronic components.

12. A preparation method for a radio frequency module, comprising:
providing a first electronic component and a second electronic component, wherein the first electronic component comprises a first connection pad, and the second electronic component comprises a second connection pad;
covering the first electronic component and the second electronic component with a dielectric layer, wherein the dielectric layer comprises first through holes and a second through hole, and a quantity of the first through holes is m; and
forming a conductive layer on the dielectric layer, wherein the conductive layer comprises first conductive branches and a second conductive branch; and a quantity of the first conductive branches is m, an i^{th} first conductive branch is electrically connected to the first connection pad through an i^{th} first through hole, and the second conductive branch is electrically connected to the second connection pad through the second through hole, wherein m is an integer greater than or equal to 2, and i is a positive integer less than or equal to m.

13. The preparation method for the radio frequency module according to claim 12, wherein every at least two adjacent first conductive branches are connected to a first connection portion, and the second conductive branch is connected to the first connection portion.

14. The preparation method for the radio frequency module according to claim 12 or 13, wherein a quantity of second through holes is n, a quantity of second conductive branches is n, and a j^{th} second conductive branch is electrically connected to the second connection pad through a j^{th} second through hole, wherein n is an integer greater than or equal to 2, and i is a positive integer less than or equal to n.

15. The preparation method for the radio frequency module according to claim 14, wherein every at least two adjacent second conductive branches are connected to a second connection portion; and
the conductive layer further comprises a connected conductive branch, and the connected conductive branch is separately connected to the first connection portion and the second connection portion.

16. The preparation method for the radio frequency module according to any one of claims 13 to 15, wherein a total length of any one of the first conductive branches is L1, and a total length of another first conductive branch ranges from (1-0.3)L1 to (1+0.3)L1, wherein L1 is a positive number; and/or
when the quantity of the second conductive branches is n, a total length of any one of the second conductive branches is L2, and a total length of another second conductive branch ranges from (1-0.3)L2 to (1+0.3)L2, wherein L2 is a positive number.

17. The preparation method for the radio frequency module according to claim 16, wherein total lengths of the m first conductive branches are the same; and/or
when the quantity of the second conductive branches is n, total lengths of the n second conductive branches are the same.

18. An electronic device, comprising a circuit board and the radio frequency module according to any one of claims 1 to 11, wherein the radio frequency module is arranged on the circuit board.
